# EUROPÄISCHE PATENTANMELDUNG

(11) **EP 3 996 476 A1**
(43) Veröffentlichungstag der Anmeldung: **11.05.2022**
(21) Anmeldenummer: 20465584.9
(22) Anmeldetag: 05.11.2020
(51) Int. Cl.: H05K 5/00, H05K 7/14

(54) **GEHÄUSESCHALE FÜR EIN GEHÄUSE ZUR AUFNAHME EINER ELEKTRISCHEN LEITERPLATTE SOWIE BAUGRUPPE MIT EINEM GEHÄUSE MIT EINER SOLCHEN GEHÄUSESCHALE**

(71) Anmelder: Continental Automotive GmbH, 30165 Hannover (DE)
(72) Erfinder: Maftei, Alexandru - c/o Conti Temic microelectronic GmbH, 90411 Nürnberg (DE); Stanicel, Andrei - c/o Conti Temic microelectronic GmbH, 90411 Nürnberg (DE); Petrovan, Stefan - c/o Conti Temic microelectronic GmbH, 90411 Nürnberg (DE)
(74) Vertreter: Continental Corporation

(57) **Zusammenfassung**

Die Erfindung betrifft eine Gehäuseschale für ein Gehäuse zur Aufnahme einer elektrischen Leiterplatte bestehend aus einem Gehäuseboden (10) sowie dazu senkrecht angeordneten Seitenwänden (12) und zumindest einer Gehäuseöffnung zum Einführen der Leiterplatte. In den Ecken der Seitenwände (12) sich vom Gehäuseboden aus in eine vorgegebene Höhe (Z11) kleiner als die Höhe (Z12) der Seitenwände ragende Befestigungsstellen (11) vorgesehen sind, an denen zumindest die elektrische Leiterplatte in dieser Höhe (Z11) der Befestigungsstellen (11) parallel zum Gehäuseboden (10) befestigbar sind.

Es ist dabei eine Mehrzahl von zusätzlichen Halterippen (13) vorgesehen, wobei die Halterippen (13) jeweils eine Dicke (X13= Y12±15%*Y12) aufweisen, welche um höchstens 15% von der Dicke der Seitenwände (Y12) abweicht und zumindest zwei dieser Halterippen (13) eine gemeinsame Gruppe (GX.1, GX.2,GY) von Halterippen bilden, die zueinander jeweils nur um einen Abstand (14) voneinander beabstandet sind, welcher höchstens 15% von der Dicke der Halterippen abweicht (X14= X13± 15%*X13).

## Beschreibung

Die Erfindung betrifft eine Gehäuseschale für ein Gehäuse zur Aufnahme einer elektrischen Leiterplatte gemäß dem Oberbegriff des Anspruchs 1.

Gehäuse zur Aufnahme einer elektrischen Leiterplatte bestehen üblicherweise aus zwei Gehäusehälften, wobei zwischen diesen eine Leiterplatte angeordnet ist und durch geeignete Befestigungsmittel, wie beispielsweise Schrauben an Befestigungsstellen die Gehäusehälften als auch die dazwischen liegende Leiterplatte befestigt werden. Zumindest eine Gehäusehälfte ist dabei als Gehäuseschale ausgebildet. Die Gehäuseschale weist einen Gehäuseboden sowie dazu senkrecht angeordnete Seitenwände und zumindest eine Gehäuseöffnung zum Einführen der Leiterplatte auf.

In den Ecken der Seitenwände sind vom Gehäuseboden aus ragende Befestigungsstellen vorgesehen, deren vorgegebene Höhe kleiner als die Höhe der Seitenwände ist. An diesen Befestigungsstellen ist zumindest die elektrische Leiterplatte in dieser Höhe parallel zum Gehäuseboden befestigbar bzw. im montierten Zustand befestigt. Vorzugsweise wird zugleich auch die andere Gehäusehälfte befestigt.

Generell ist es darüber hinaus auch bekannt, zusätzlich Halterippen an der Seitenwand des Gehäuses vorzusehen, welche in rechtem Winkel zu dieser Seitenwand als auch rechtem Winkel zum Gehäuseboden und mit einer Höhe entsprechend der Höhe der Befestigungsstellen ausgestaltet sind, so dass die Leiterplatte auf diesen Halterippen zusätzlich halten.

Für eine hinreichende Haltewirkung sind diese Halterippen üblicherweise in einer Breite bzw. Dicke vorgesehen, welche um ein Vielfaches größer ist als die Breite bzw. Dicke der Seitenwände. Bei einer thermischen Fertigung einer solchen Gehäuseschale können solche großen Halterippen jedoch zu Verspannungen in der Gehäuseschale selbst führen.

Darüber hinaus sind umlaufende Halteränder bekannt, welche jedoch den Nachteil aufweisen, dass diese zum einen entsprechend viel Material benötigen und zudem deren Oberfläche oft nicht so exakt parallel zum Gehäuseboden gefertigt werden kann, dass die Leiterplatte an allen Stellen immer exakt aufliegt.

Des Weiteren ist bekannt, beabstandet von den Seitenwänden im Inneren weitere Halte- oder Befestigungsstellen vorzusehen, welche natürlich eventuelle Schwingungen der Leiterplatte ebenfalls reduzieren können, jedoch den großen Nachteil aufweisen, dass diese die mit elektronischen Bauelementen zu bestückende Fläche der Leiterplatte einschränken.

Aufgabe der Erfindung ist es daher, eine besonders geeignete Ausgestaltung einer Gehäuseschale vorzustellen, welche einerseits einen geringen Material- und Herstellungsaufwand aufweist und andererseits die Leiterplatte doch hinreichend hält und vor Schwingungen schützt. Diese Aufgabe wird durch die Merkmale des Anspruchs 1 gelöst. Vorteilhafte Weiterbildungen sind den Unteransprüchen zu entnehmen.

Eine gattungsgemäße Gehäuseschale für ein Gehäuse zur Aufnahme einer elektrischen Leiterplatte besteht also aus einem Gehäuseboden sowie dazu senkrecht angeordneten Seitenwänden vorzugsweise an zumindest drei der Seiten, wobei anstelle der vierten Seitenwand beispielsweise auch der Bereich für einen Steckeranschluss vorgesehen oder aber auch diese Seite durch eine Seitenwand versehen sein kann. Es ist zumindest eine Gehäuseöffnung zum Einführen der Leiterplatte vorgesehen, wobei diese gegenüber dem Gehäuseboden angeordnet sein kann oder beispielsweise auch an jener Seite, welche dann durch den Steckeranschluss verschlossen wird. Die Gehäuseöffnung kann durch einen einfachen Deckel, einen Kunststofferguss oder auch durch eine weitere erfindungsgemäß geformte Gehäuseschale verschlossen werden. In den Ecken der Gehäuseschale nahe der Seitenwände sind Befestigungsstellen vorgesehen, welche sich vom Gehäuseboden aus in eine vorgegebene Höhe kleiner als die Höhe der Seitenwände herausragend erstrecken und an denen zumindest die elektrische Leiterplatte in dieser Höhe der Befestigungsstellen parallel zum Gehäuseboden befestigbar sind, im montierten Zustand des Gehäuses also befestigt ist.

Es sind ist zumindest an der längsten Seitenwand des Gehäuses, vorzugsweise aber an allen vorhandenen Seitenwänden jeweils eine Mehrzahl, also mindestens zwei, von zusätzlichen Halterippen vorgesehen. Die Halterippen in rechtem Winkel zu dieser Seitenwand als auch rechtem Winkel zum Gehäuseboden angeordnet und mit einer Höhe entsprechend der Höhe der Befestigungsstellen ausgestaltet, sodass die Leiterplatte über die Befestigungsstellen und zusätzlichen Halterippen in einer Ebene parallel zum Gehäuseboden gehalten wird. Die Befestigungsstellen sind dabei jeweils voneinander beabstandet angeordnet und ragen um eine vorgegebene Länge parallel zum Gehäuseboden ins Innere des Gehäuses. Anstelle eines umlaufenden Halterandes oder breiter Halterippen ist jedoch erfindungsgemäß vorgesehen, dass die Halterippen jeweils nur eine Dicke aufweisen, welche um höchstens 15% von der Dicke der Seitenwände abweicht. Zudem bilden zumindest zwei dieser Halterippen jeweils eine gemeinsame Gruppe von Halterippen, die zueinander jeweils nur um einen Abstand voneinander beabstandet sind, welcher höchstens 15% von der Dicke der Halterippen abweicht. Dabei stellt die Abweichung von +/-15 % bereits eine Grenze dar, welche in den vorgesehenen Anwendungen bereits gewisse Nachteile in Kauf nimmt und jede Reduzierung der Abweichungen zu einer Verbesserung der Gesamtwirkung führt, daher bevorzugt nur eine Toleranz von 5 % vorgesehen und ein Optimum bei annähernder Übereinstimmung der Breite festgestellt wurde, wobei natürlich fertigungstechnisch bedingte Toleranzen immer berücksichtigt werden müssen. Diese Gruppe als Abfolge von dünnen Halterippen und geringen Abständen wirkt schwingungstechnisch dabei für die Leiterplatte quasi wie eine durchgehende Fläche, also wie eine einzige Halterippe mit einer Dicke entsprechend der Gesamtbreite der Gruppe, ist jedoch andererseits mit deutlich weniger Material als auch fertigungstechnisch leichter herzustellen.

Diese Gruppe von Halterippen als Abfolge von dünnen Halterippen und geringen, näherungsweise identisch breiten Abständen erstreckt sich jedoch nicht über die Seitenwände komplett sondern nur innerhalb einer Gruppe und weist diese Gruppe von Halterippen zu den Befestigungsstellen und weiteren Gruppen, sofern an dieser Seitenwand weitere Gruppen vorhanden sind einen Abstand auf, der zumindest doppelt so groß ist wie der Abstand der Halterippen innerhalb einer gemeinsamen Gruppe. Vorzugsweise ist der Abstand der Gruppen zueinander als auch zu den Befestigungsstellen sogar noch deutlich größer als das Doppelte, insbesondere mehr als das Zehnfache jenes Abstands zwischen den Halterippen innerhalb der Gruppe.

Vorzugsweise ist die eine oder die Mehrzahl von Gruppen von Halterippen jeweils spiegelsymmetrisch zur Mitte der Seitenwand zwischen den Befestigungsstellen angeordnet. Ist also nur eine einzige Gruppe von Halterippen an einer Seitenwand vorgesehen, so wird diese mittig spiegelsymmetrisch angeordnet sein. Ebenso die jeweils mittlere Gruppe bei einer ungeraden Anzahl von Gruppen. Ist jedoch eine gerade Anzahl von Gruppen vorgesehen, sind diese eben beabstandet von dieser Mitte angeordnet.

In einer bevorzugten Ausgestaltung sind gerade bei einer Gehäuseschale mit zwei ungleich langen Seitenwänden an der längeren Seitenwand eine größere Anzahl von Gruppen von Halterippen als an der kürzeren Seitenwand angeordnet, dann aber eventuell eben innerhalb der Gruppen weniger Halterippen vorgesehen. Zudem erweist es sich als vorteilhaft, dass bei einer Gehäuseschale mit zwei ungleich langen Seitenwänden an der längeren Seitenwand über sämtliche Gruppen von Halterippen hinweg mehr Halterippen angeordnet sind als an der kürzeren Seitenwand.

In einer besonders bevorzugten Weiterbildung der Erfindung weisen zudem die Befestigungsstellen selbst ebenfalls jeweils eine zusätzliche Halterippen zumindest ins Innere des Gehäuses in Richtung parallel der längsten Seitenwand auf, d. h. dass die Befestigungsstellen neben einer üblicherweise runden Auflagefläche um die Öffnung in der Befestigungsstellen darüber hinaus auf der gleichen Höhe verbleibende seitliche Stege als Halterippen aufweisen, welche die wirksame Auflagefläche der Befestigungsstellen in die entsprechenden Richtungen entsprechend vergrößern.

Die konkrete Anzahl der Halterippen je Gruppe als auch die Anzahl der Gruppen und damit implizit auch der Abstand der Gruppen untereinander bzw. zu den Befestigungsstellen ist anwendungsspezifisch zumindest in Abhängigkeit von Parametern der Leiterplatte, beispielsweise der Abmessungen der Leiterplatte, deren Steifigkeit sowie der Bestückung der Leiterplatte bestimmt. Vorzugsweise erfolgt dies durch eine Schwingungssimulation des Gehäuses mit der befestigten und bestückten Leiterplatte bei zumindest einer vorgegebenen Anregungsfrequenz und ist die Anzahl der Halterippen je Gruppe als auch die Anzahl der Gruppen so bestimmt, dass die Schwingung der Leiterplatte zumindest kleiner als eine Höchstzulassungsgrenze ist, vorzugsweise miniert ist.

Zudem wird eine elektronische Baugruppe mit einem Gehäuse mit einer Leiterplatte sowie zumindest einer Gehäuseschale nach einem der Ansprüche beschrieben. Die Erfindung wird nachfolgend anhand von Ausführungsbeispielen unter Bezugnahme auf die Figuren näher erläutert. Während bestimmte Teile der Gehäuseschale bzw. der Baugruppe mit Ziffern bezeichnet werden, wurde für die Bezeichnung von Abmaßen dieser Teile jeweils die Ziffer mit einem entsprechenden Buchstaben entsprechend der Richtung der Maße in Bezug auf ein einheitliches rechtwinkliges Koordinatensystem X,Y,Z gewählt, um das Verständnis sowie die Ausrichtung der Abmaße besser verdeutlichen zu können.

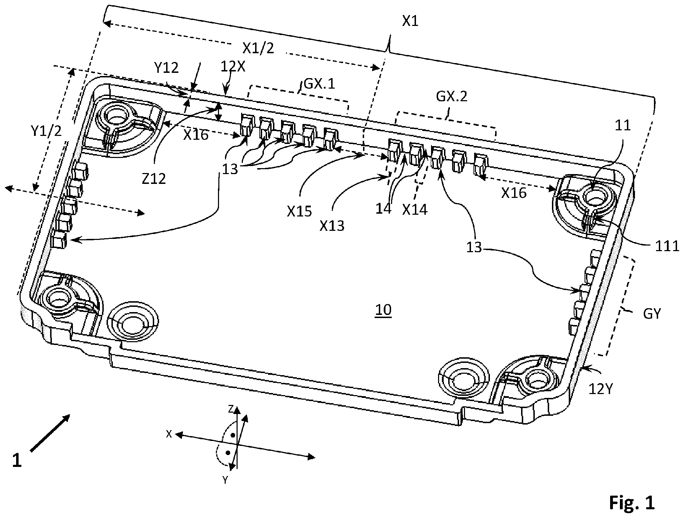

So zeigt die Figur 1 eine Gehäuseschale 1 gemäß einer besonders bevorzugten Ausgestaltung der Erfindung, bei welcher sich vom Gehäuseboden 10 aus an 3 der Seiten jeweils eine vollständige Seitenwand 12 befindet, während auf der in Fig. 1 vorderen Seite keine vollständige Seitenwand vorhanden ist, sondern eine Aussparung, in welche nachfolgend der Steckerbereich an der Leiterplatte mit eingesetzt wird. An der gegenüberliegenden sich in X-Richtung erstreckenden und damit längsten Seitenwand 12X als auch hier in der bevorzugten Ausgestaltung den dazu benachbarten Seitenwänden 12 Y in Y-Richtung sind Halterippen 13 angeordnet.

In den Ecken der Seitenwände 12 sind Befestigungsstellen 11 vorgesehen, welche sich vom Gehäuseboden aus in eine vorgegebene Höhe Z11 kleiner als die Höhe Z12 der Seitenwände erstrecken. Die Befestigungsstellen 11 weisen dabei in herkömmlicher Weise eine Öffnung für das Durchführen eines Befestigungsmittels, beispielsweise einer Schraube sowie einen umlaufenden Rand auf, wobei auf diesem Rand die elektrische Leiterplatte in dieser Höhe Z11 der Befestigungsstellen 11 parallel zum Gehäuseboden 10 befestigbar ist.

Die Halterippen 13 sind in rechtem Winkel zur jeweiligen Seitenwand (12X bzw. 12Y) als auch rechtem Winkel zum Gehäuseboden 10 angeordnet. Die Höhe der Halterippen 13 ist entsprechend der Höhe der Befestigungsstellen 11 gewählt, also Z13= Z11. Die Halterippen 13 sind zueinander als auch zu den Befestigungsstellen 11 beabstandet angeordnet und ragen parallel zum Gehäuseboden 10 um eine vorgegebene Länge ins Innere des Gehäuses, für die Halterippen an der längsten Seitenwand 12 X wäre dies in Y-Richtung.

Eine wesentliche Besonderheit dieser Erfindung ist jedoch, dass die Halterippen 13 jeweils nur eine Dicke X13 aufweisen, welche um höchstens 15% von der Dicke der Seitenwände Y12 abweicht, also als Formel ausgedrückt X13= Y12±15%*Y12 gilt. Zudem bilden zumindest zwei, hier jedoch in Fig. 1 jeweils 5 dieser Halterippen 13 eine gemeinsame Gruppe GX.1, GX.2,GY von Halterippen, wobei die Halterippen einer Gruppe zueinander jeweils nur um einen Abstand 14 voneinander beabstandet sind, welcher höchstens 15% von der Dicke der Halterippen abweicht, also als Formel ausgedrückt X14= X13± 15%*X13 gilt.

Zudem weist diese Gruppe GX.1, GX.2,GY von Halterippen zu den Befestigungsstellen 11 und, sofern vorhanden, weiteren Gruppen von Halterippen einen Abstand X15,X16 auf, der zum indest doppelt so groß ist wie der Abstand X14 der Halterippen 13 innerhalb einer gemeinsamen Gruppe GX.1, GX.2,GY. Wie in Figur 1 deutlich zu erkennen, sind in dieser Ausgestaltung die Abstände X auch um deutlich mehr als das Doppelte 15 und X16, eher mehr als das Zehnfache größer als der Abstand X14 zwischen 2 benachbarten Halterippen innerhalb einer Gruppe. Zudem ist in der bevorzugten Ausgestaltung der Figur 1 zu erkennen, dass auf der mit einer Länge von X1 längsten Seitenwand 12X 2 Gruppen GX.1, GX.2 von Halterippen 13 angeordnet sind, während auf der demgegenüber kürzeren Seitenwand 12Y nur eine Gruppe GY angeordnet ist. Die Gruppen sind jedoch jeweils gemäß der bevorzugten Ausgestaltung spiegelsymmetrisch zur Mitte der Seitenwand zwischen den Befestigungsstellen 11 angeordnet, wie in Figur 1 skizzenhaft gestrichelt an den Positionen mit den Abständen X1/2 für die Seitenwand 12X und an Position Y1/2 für die Seitenwände 12Y dargestellt. Ist an einer Seitenwand also nur eine oder eine ungeradzahlige Anzahl von Gruppen vorgesehen, so wird deren mittlere Gruppe GY in sich spiegelsymmetrisch zu dieser Mitte Y1/2 angeordnet, hier also bei wiederum einer ungeradzahligen Anzahl von 5 Halterippen deren mittlere gerade auf dieser Mitte Y1/2 angeordnet, bei einer geraden Anzahl von Halterippen diese entsprechend versetzt aber weiterhin spiegelsymmetrisch angeordnet.

An der längsten Seitenwand 12 X ist zu erkennen, dass die 2 Gruppen GX.1 und GX.2 ebenfalls spiegelsymmetrisch zur Mitte X1/2 der Länge X1 der Gehäuseschale1 angeordnet sind.

Auf der Oberseite der Halterippen 13 kommt also die in den Figuren nicht dargestellte Leiterplatte der gleichen Ebene mit den Befestigungsstellen 11 zur Anlage parallel zum Gehäuseboden 10. die Gruppen GX.1, GX.2,GY von Halterippen 13 wirken dabei erfindungsgemäß näherungsweise jeweils wie eine Stützfläche entsprechend der Breite der gesamten Gruppe, obwohl die Halterippen 13 ja jeweils durch die Abstände 14 voneinander unterbrochen sind.

In der vorliegenden Ausgestaltung kamen nun gerade auf der langen Seite 12X zwei Gruppen mit je 5 Halterippen und auf der kurzen Seite 12Y jeweils eine Gruppe mit ebenfalls 5 Halterippen als beste Lösung aus der Simulation heraus, sei jedoch klargestellt, dass eben auch eine abweichende Anzahl von Halterippen bei anderen Dimensionen der Leiterplatte oder deren Bestückung denkbar ist, bspw. auf der langen Seiten auch zwei Gruppen mit bspw. 4 Halterippen, wobei vorzugsweise die Summe , hier also 8 Halterippen auf der langen Seiten noch größer ist als die Summe, hier 5 auf der kurzen Seite.

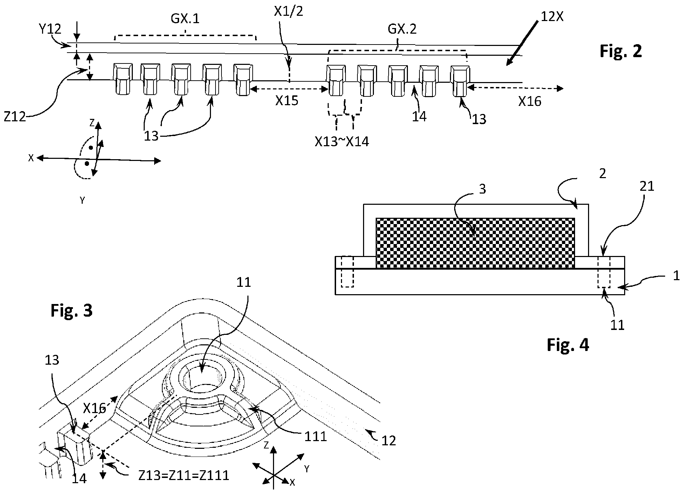

Die Figur 2 zeigt noch mal eine Detailansicht auf die Seitenwand 12 X mit den 2 Gruppen von Halterippen, wie diese jedoch bereits bzgl. Fig. 1 umfassend erläutert wurde.

Figur 3 zeigt in Vergrößerung eine besondere Weiterbildung, welche zwar auch schon in Fig. 1 gezeigt, bisher aber noch nicht so ausführlich diskutiert wurde, wie dies nun erfolgen soll. So weisen nämlich die Befestigungsstellen 11 ebenfalls jeweils eine zusätzliche Halterippen 111 zumindest ins Innere des Gehäuses in Richtung parallel der längsten Seitenwand 12X auf, hier sogar in beide Richtungen, also auch in Y-Richtung auf. Dadurch vergrößert sich die auf die Leiterplatte wirkende Auflagefläche der Befestigungsstelle 11 nochmals.

Die Höhe in Z-Richtung von Befestigungsstelle 11 selbst als auch dessen Halterippen 111 als auch der Halterippen 13 ist dabei in Bezug auf den Gehäuseboden gleich, damit die Leiterplatte eben und parallel zum Gehäuseboden liegt.

Fig.4 skizziert nun noch der Vollständigkeit halber eine elektronische Baugruppe mit einer solchen erfindungsgemäßen Gehäuseschale 1 sowie einer zweiten Gehäuseschale 2 sowie einer Leiterplatte mit einem daran befindlichen Steckerbereich 3, welcher auf der hier in der Fig.4 vorderen Gehäusewand angeordnet ist. Zudem sind Befestigungsstellen 21 jeweils entsprechend zu den Befestigungsstellen 11 ausgerichtet und können dort nicht näher gezeigte Befestigungsmittel, bspw. Schrauben, zum Verschließen des Gehäuses vorgesehen sein, welche vorzugsweise auch zugleich die Leiterplatte dazwischen mit einspannen.

Die Gehäuseschale bzw. das gesamte Gehäuse können sowohl aus Kunststoff oder auch Metall sein und eignet sich die Erfindung in beiden Fällen. Wie an sich bekannt, kann bei metallischen Gehäusen auch die elektrische Erdung über das Gehäuse erfolgen, wobei neben oder anstelle des Kontakts über die Befestigungsstellen dies ggfs. auch über die Halterippen erfolgen kann und durch Halterippen auf beiden Gehäusehälften sogar die Wirkung eines Faraday'schen Käfigs durch die Halterippen noch verstärkt werden.

## Patentansprüche

1. Gehäuseschale (1) für ein Gehäuse zur Aufnahme einer elektrischen Leiterplatte bestehend aus einem Gehäuseboden (10) sowie dazu senkrecht angeordneten Seitenwänden (12) und zumindest einer Gehäuseöffnung zum Einführen der Leiterplatte,
wobei in den Ecken der Seitenwände (12) sich vom Gehäuseboden aus in eine vorgegebene Höhe (Z11) kleiner als die Höhe (Z12) der Seitenwände ragende Befestigungsstellen (11) vorgesehen sind, an denen zumindest die elektrische Leiterplatte in dieser Höhe (Z11) der Befestigungsstellen (11) parallel zum Gehäuseboden (10) befestigbar sind,
eine Mehrzahl von zusätzlichen Halterippen (13) zumindest an der längsten (X1>Y1) Seitenwand (12X) des Gehäuses vorgesehen sind, die Halterippen (13) in rechtem Winkel zu dieser Seitenwand (12X) als auch rechtem Winkel zum Gehäuseboden (10) und mit einer Höhe (Z13= Z 11) entsprechend der Höhe der Befestigungsstellen (11) ausgestaltet und zueinander als auch zu den Befestigungsstellen (11) beabstandet angeordnet sind und um eine vorgegebene Länge (Y13) parallel zum Gehäuseboden (10) ins Innere des Gehäuses ragen, **dadurch gekennzeichnet, dass**
die Halterippen (13) jeweils eine Dicke (X13= Y12±15%*Y12) aufweisen, welche um höchstens 15% von der Dicke der Seitenwände (Y12) abweicht,
zumindest zwei dieser Halterippen (13) eine gemeinsame Gruppe (GX.1, GX.2, GY) von Halterippen bilden, die zueinander jeweils nur um einen Abstand (14) voneinander beabstandet sind, welcher höchstens 15% von der Dicke der Halterippen abweicht (X14= X13± 15%*X13) und
diese Gruppe (GX.1, GX.2,GY) von Halterippen zu den Befestigungsstellen (11) und, sofern vorhanden weiteren Gruppen von Halterippen einen Abstand (X15,X16) aufweist, der zumindest doppelt so groß ist wie der Abstand (X14) der Halterippen (13) innerhalb einer gemeinsamen Gruppe (GX.1, GX.2,GY).

2. Gehäuseschale nach Anspruch 1, **dadurch gekennzeichnet, dass** die eine oder die Mehrzahl von Gruppen (GX.1, GX.2,GY) von Halterippen (13) jeweils spiegelsymmetrisch zur Mitte (X1/2; Y1/2) der Seitenwand zwischen den Befestigungsstellen (11) angeordnet ist.

3. Gehäuseschale nach Anspruch 1 oder 2, **dadurch gekennzeichnet, dass** bei einer Gehäuseschale mit zwei ungleich langen (X1>Y1) Seitenwänden (12) an der längeren Seitenwand (12X) eine größere Anzahl von Gruppen (GX.1, GX.2) von Halterippen (13) als an der kürzeren Seitenwand (12Y) angeordnet sind.

4. Gehäuseschale nach einem der vorangehenden Ansprüche, **dadurch gekennzeichnet, dass** bei einer Gehäuseschale mit zwei ungleich langen Seitenwänden an der längeren Seitenwand (12X) über sämtliche Gruppen (GX.1, GX.2) von Halterippen hinweg mehr Halterippen angeordnet sind als an der kürzeren Seitenwand (12Y).

5. Gehäuseschale nach einem der vorangehenden Ansprüche, **dadurch gekennzeichnet, dass** die Befestigungsstellen (11) ebenfalls jeweils eine zusätzliche Halterippen (111) zumindest ins Innere des Gehäuses in Richtung parallel der längsten Seitenwand (12X) aufweisen.

6. Gehäuseschale nach einem der vorangehenden Ansprüche, **dadurch gekennzeichnet, dass** die Anzahl der Halterippen je Gruppe als auch die Anzahl der Gruppen anwendungsspezifisch zumindest in Abhängigkeit von Parametern der Leiterplatte, beispielsweise der Abmessungen der Leiterplatte, deren Steifigkeit sowie der Bestückung der Leiterplatte bestimmt ist.

7. Gehäuseschale nach Anspruch 6, dass durch eine Schwingungssimulation des Gehäuses mit der befestigten und bestückten Leiterplatte bei zumindest einer vorgegebenen Anregungsfrequenz erfolgt und die die Anzahl der Halterippen je Gruppe als auch die Anzahl der Gruppen so bestimmt ist, dass die Schwingung der Leiterplatte zumindest kleiner als eine Höchstzulassungsgrenze ist, vorzugsweise miniert ist.

8. Gehäuseschale nach einem der vorangehenden Ansprüche, **dadurch gekennzeichnet, dass** die Halterippen (13) jeweils eine Dicke (X13= Y12±5%*Y12) aufweisen, welche um höchstens 5% von der Dicke der Seitenwände (Y12) abweicht und zueinander jeweils nur um einen Abstand (14) voneinander beabstandet sind, welcher höchstens 5% von der Dicke der Halterippen (X14= X13± 5%*X13) abweicht.

9. Elektronische Baugruppe mit einem Gehäuse mit einer Leiterplatte sowie zumindest einer Gehäuseschale (1) nach einem der vorangehenden Ansprüche.
